(19) Europäisches Patentamt

European Patent Office

Office européen des brevets

(11) **EP 0 924 525 B1**

(12) **FASCICULE DE BREVET EUROPEEN**

(45) Date de publication et mention
de la délivrance du brevet:
**09.06.2004   Bulletin 2004/24**

(51) Int Cl.⁷: **G01R 27/26**, G01D 5/241,
G01D 18/00, G01P 21/00

(21) Numéro de dépôt: **97122213.8**

(22) Date de dépôt: **17.12.1997**

(54) **Procédure de caractérisation d'un convertisseur en tension connecté à un montage capacitif**

Verfahren zur Einstellung einer eine kapazitive Grösse in eine korrespondierende Spannung umsetzende Signalverarbeitungsschaltung

Procedure for adjusting a signal conditioning circuit, which converts a capacitance value into a corresponding voltage

(84) Etats contractants désignés:
**AT BE DE FR GB NL**

(43) Date de publication de la demande:
**23.06.1999   Bulletin 1999/25**

(73) Titulaire: **EM Microelectronic-Marin SA**
**2074 Marin (CH)**

(72) Inventeurs:
• **Olivier, Rey**
**2523 Lignières (CH)**
• **Antal, Banyai**
**2000 Neuchâtel (CH)**

(74) Mandataire: **Balsters, Robert et al**
**I C B,**
**Ingénieurs Conseils en Brevets S.A.,**
**7, rue des Sors**
**2074 Marin (CH)**

(56) Documents cités:
**DE-A- 3 013 284**          **DE-A- 4 209 140**
**US-A- 5 253 510**          **US-A- 5 540 095**

**Description**

La présente invention concerne le domaine des circuits intégrés et, plus particulièrement, des procédures de caractérisation de convertisseurs en tension connectés à un montage capacitif.

Il existe une grande variété de capteurs tant par leurs formes, leurs fonctions, leurs effets que par leurs applications.

Dans le cadre de la détection d'un paramètre tel que l'accélération ou la pression, on utilise communément un capteur capacitif que l'on décrit ci-dessous.

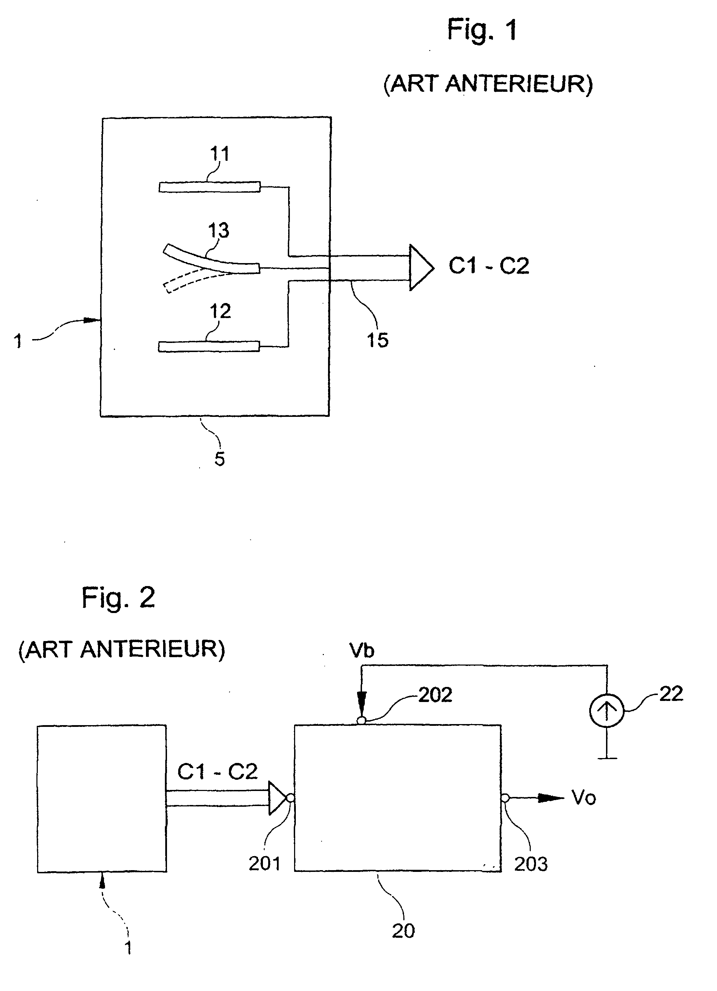

La figure 1 représente un capteur capacitif classique 1.

Le capteur 1 est agencé de manière à pouvoir mesurer un paramètre tel que la pression ambiante ou l'accélération subie par ce capteur. A cet effet, le capteur 1 comprend un support 5, deux armatures 11 et 12 qui sont fixes par rapport à ce support, et une troisième armature 13 qui est aménagée de manière à être mobile entre les deux armatures 11 et 12.

Un schéma électrique équivalent du capteur 1 peut être représenté par deux capacités C1 et C2 connectées en série. Dans une telle représentation, la capacité C1 correspond à la capacité du condensateur formé par les armatures 11 et 13, et la capacité C2 correspond à la capacité du condensateur formé par les armatures 12 et 13.

Le capteur capacitif 1 est agencé également de manière à pouvoir fournir une différence de capacité C1-C2 qui est fonction dudit paramètre. A cet effet, le capteur 1 comprend une borne de connexion 15 pour pouvoir fournir une telle différence.

Le fonctionnement du capteur 1 est le suivant. Sous l'effet dudit paramètre, l'armature mobile 13 se déplace dans le capteur 1, et ce dernier fournit en réponse la différence de capacité C1-C2 qui représente la disposition des trois armatures 11 à 13, suite audit effet.

Dans le cadre de la détection d'un paramètre tel que la pression ou l'accélération, un tel capteur capacitif est connecté à un convertisseur en tension, de sorte que le circuit formé du capteur et du convertisseur, fournit une tension électrique qui représente l'évolution du paramètre.

La figure 2 représente un tel circuit connu comprenant le capteur 1 de la figure 1, qui est connecté à un convertisseur en tension 20.

Le convertisseur 20 comprend deux bornes d'entrée 201 et 202 et une borne de sortie 203. Le convertisseur 20 est connecté et agencé de manière à pouvoir recevoir, par la borne 201, la différence de capacité C1-C2 fournie par le capteur 1 et, par la borne 202, une tension de polarisation Vb fournie par une source de tension constante 22. Le convertisseur 20 est agencé de manière à pouvoir fournir, par la borne 203, une tension de sortie Vo qui dépend de la différence de capacité C1-C2 et de la tension de polarisation Vb.

On note que la tension de polarisation Vb peut être unipolaire ou bipolaire, et référencée par rapport au potentiel de masse du circuit. On rappelle en outre que la tension de polarisation Vb est utilisée typiquement pour fixer à une valeur prédéterminée le gain statique du circuit constitué du capteur 1 et du convertisseur 20.

De façon générale, les procédures de caractérisation classiques d'un tel convertisseur, reposent sur la détermination de la caractéristique de la tension de sortie Vo en fonction de la différence de capacité C1-C2 et, en particulier, des performances électriques de ce convertisseur.

On rappelle que les "performances électriques" d'un convertisseur sont caractérisés habituellement par deux paramètres électriques : le gain statique As et le coefficient de non-linéarité $L_{As}$. On rappelle également que le gain statique As du convertisseur est égal à $\frac{Vb}{C1+C2}$, en se référant à la figure 2, et que le coefficient de non-linéarité $L_{As}$ représente la dispersion de la tension de sortie Vo entre les valeurs effectives de cette tension et des valeurs de tension correspondant à un comportement linéaire idéal du convertisseur.

Une difficulté communément rencontrée pour réaliser une telle caractérisation, réside dans la fourniture d'une pluralité de différences de capacité C1-C2, pour mesurer l'évolution de la tension de sortie Vo avec la différence de capacité C1-C2.

En effet, dans le cas où le convertisseur est connecté à un capteur capacitif tel que décrit en relation avec la figure 1, la variation du paramètre susceptible de provoquer une différence de capacité C1-C2 est difficile à générer dans un environnement industriel de production, notamment dans les usines de fabrication de semi-conducteurs qui sont soumises à des préoccupations de rendement.

Pour répondre à de telles préoccupations, on utilise en tant que capteur capacitif un circuit dont le schéma électrique équivalent est proche de celui d'un capteur capacitif, c'est-à-dire un circuit qui fournit un signal électrique susceptible de représenter une différence de capacité. Dans la suite de la description, un tel circuit est appelé "montage capacitif".

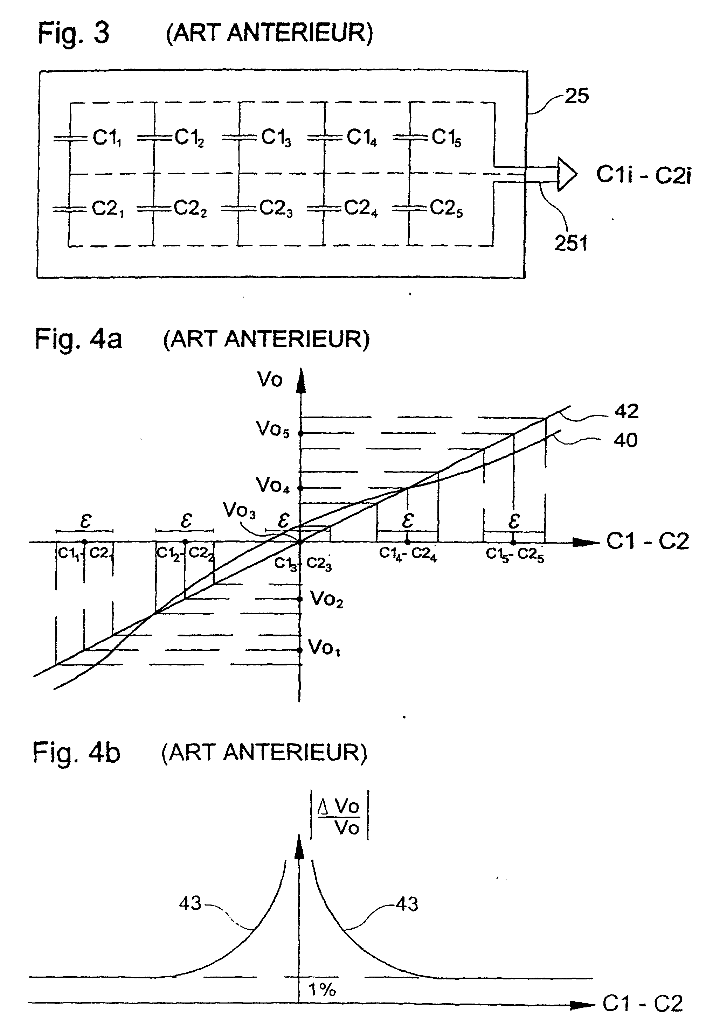

A titre illustratif, la figure 3 représente un montage capacitif 25 classique, susceptible de fournir cinq valeurs de différence de capacité $C1_i$-$C2_i$, i = 1, 2, 3, 4, 5.

A cet effet, le montage capacitif 25 comprend des moyens de connexion 251, et cinq premiers condensateurs $C1_i$ (i = 1, 2, 3, 4, 5) connectés respectivement en série à cinq seconds condensateurs $C2_i$ (i = 1, 2, 3, 4, 5). Le montage capacitif 25 est agencé de manière à pouvoir établir une connexion entre l'un des condensateurs $C1_i$, les moyens de connexion 251 et le condensateur $C2_i$ associé, de sorte que ce montage fournit, par les moyens de connexion 251, l'une des cinq valeurs de différence de capacité $C1_i$-$C2_i$.

Un problème que l'on rencontre dans la détermination des performances électriques d'un convertisseur en tension, réside dans le fait que cette détermination est peu fiable, puisque les valeurs de capacités sont entachées d'une imprécision intrinsèque liée à la tolérance sur les composants et d'une imprécision extrinsèque liée aux moyens de connexion du montage capacitif, ces imprécision étant d'autant plus gênantes que l'on désire caractérise un convertisseur capable de traiter de faibles valeurs de capacité.

La figure 4a représente une courbe 40 illustrant la caractéristique en tension du convertisseur 20 de la figure 2, qui est connecté au montage capacitif 25 de la figure 3, ainsi qu'une courbe 42 illustrant la régression linéaire de cette caractéristique.

On rappelle que le montage capacitif 25 peut fournir successivement cinq valeurs de différence de capacité $C1_i$-$C2_i$ (i = 1, 2, 3, 4, 5). Dans le cas où l'on utilise le montage capacitif 25 pour simuler le capteur capacitif 1 dans le circuit de la figure 2, on peut alors obtenir cinq valeurs de tension de sortie Vo pour les cinq valeurs de différence de capacité respectives $Vo_i$ (i = 1, 2, 3, 4, 5). Autrement dit, on obtient ainsi cinq couples de données ($C1_i$-$C2_i$, $Vo_i$).

Pour déterminer les performances électriques du convertisseur 20, telles que décrites ci-dessus, on extrapole ensuite ces cinq couples de données par une régression linéaire qui est représentée en figure 4a par la courbe 42. Cette régression permet de déterminer le gain As, ainsi que le coefficient $L_{As}$.

On note en figure 4a que l'erreur de mesure sur la tension de sortie Vo est due essentiellement à l'erreur $\varepsilon$ sur la valeur effective des différence de capacité $C1_i$-$C2_i$.

En effet, pour un capteur tel que décrit en relation avec la figure 1, ce capteur peut fournir des différences de capacité C1-C2 qui sont inférieures à quelques dizaines de femtofarads (1 fF = $10^{-15}$ F), sur une plage de variation de la différence de capacité C1-C2 qui est comprise typiquement entre quelques picofarads et quelques dizaines de picofarads (1 pF = $10^{-12}$ F). Par exemple, un convertisseur ayant une résolution de 12 bits permet de mesurer une variation de 2,4 fF, pour une plage de variation de 10 pF.

La figure 4b représente une courbe théorique 43 illustrant une précision relative désignée $\Delta Vo/Vo$, qui est liée à la tension de sortie Vo obtenue à partir de la figure 4a, en fonction de la différence de capacité C1-C2. On note en figure 4b que la précision de mesure des performances électriques du convertisseur 20, déterminées par une telle procédure de caractérisation, est entachée de l'erreur $\varepsilon$ qui est typiquement de l'ordre de 1 %, cette valeur ayant été établie par la Demanderesse de la présente invention, en considérant des capacités dont les tolérances sont de l'ordre de 1 %. On note que cette erreur est d'autant plus élevée que la différence de capacité mesurée est faible.

Autrement dit, une telle procédure de caractérisation ne répond pas aux exigences actuelles de précision et de rendement, qui sont des préoccupations courantes en industrie, notamment dans les usines de fabrication de semi-conducteurs.

Le document US 5 540 095 se rapporte un système d'accéléromètre utilisant un système de capacités différentielles comme capteurs.

Un objet de la présente invention est de prévoir une procédure de caractérisation d'un convertisseur en tension ou en courant connecté à un montage capacitif, cette procédure palliant les inconvénients de l'art antérieur susmentionnés, notamment en permettant de calculer avec précision la caractéristique en tension du convertisseur, en particulier ses performances électriques.

Un autre objet de la présente invention est de prévoir une procédure de caractérisation qui répond aux préoccupations courantes en industrie, notamment dans les usines de fabrication de semi-conducteurs, de précision et de rendement.

Ces objets, ainsi que d'autres, sont atteints par la procédure de caractérisation selon la revendication 1.

Un avantage de la procédure de caractérisation selon la présente invention réside dans le fait qu'elle repose sur la mesure de la tension de sortie du convertisseur, en fonction de différentes valeurs de la tension de polarisation, ce qui permet de déterminer les performances électriques du convertisseur indépendamment de l'erreur due à la mesure d'une capacité. Il en résulte une procédure qui est précise et simple à mettre en oeuvre dans un environnement industriel, notamment dans le domaine des semi-conducteurs.

Ces objets, caractéristiques et avantages, ainsi que d'autres, de la présente invention apparaîtront plus clairement à la lecture de la description détaillée d'un mode de réalisation préféré de l'invention, donné à titre d'exemple uniquement, en relation avec les figures jointes, parmi lesquelles :

- la figure 1 déjà citée représente un capteur capacitif classique;
- la figure 2 déjà citée représente un circuit comprenant le capteur de la figure 1, connecté à un convertisseur en tension;
- la figure 3 déjà citée représente un montage capacitif classique;
- la figure 4a déjà citée représente deux courbes illustrant respectivement la caractéristique d'un convertisseur en tension, et la régression linéaire de cette caractéristique, selon une procédure de caractérisation classique;
- la figure 4b déjà citée représente une courbe théorique illustrant une précision relative liée à un convertisseur en tension, en fonction d'une différence de capacité, susceptible d'être obtenue à partir d'une procédure de caractérisation classique;
- la figure 5 représente un circuit comprenant un montage capacitif, et un convertisseur en tension à caractériser par la procédure selon la présente invention;
- la figure 6 représente un organigramme de la procédure de caractérisation selon la présente invention; et

- la figure 7a représente deux courbes illustrant respectivement la caractéristique en tension d'un convertisseur, et la régression linéaire de cette caractéristique, selon la procédure de caractérisation de la figure 6; et

- la figure 7b représente une courbe théorique illustrant une précision relative liée à un convertisseur en tension, en fonction d'une tension, susceptible d'être obtenue à partir de la procédure de caractérisation selon la présente invention.

La procédure de caractérisation selon la présente invention est destinée à déterminer la caractéristique d'un convertisseur en tension connecté à un montage capacitif.

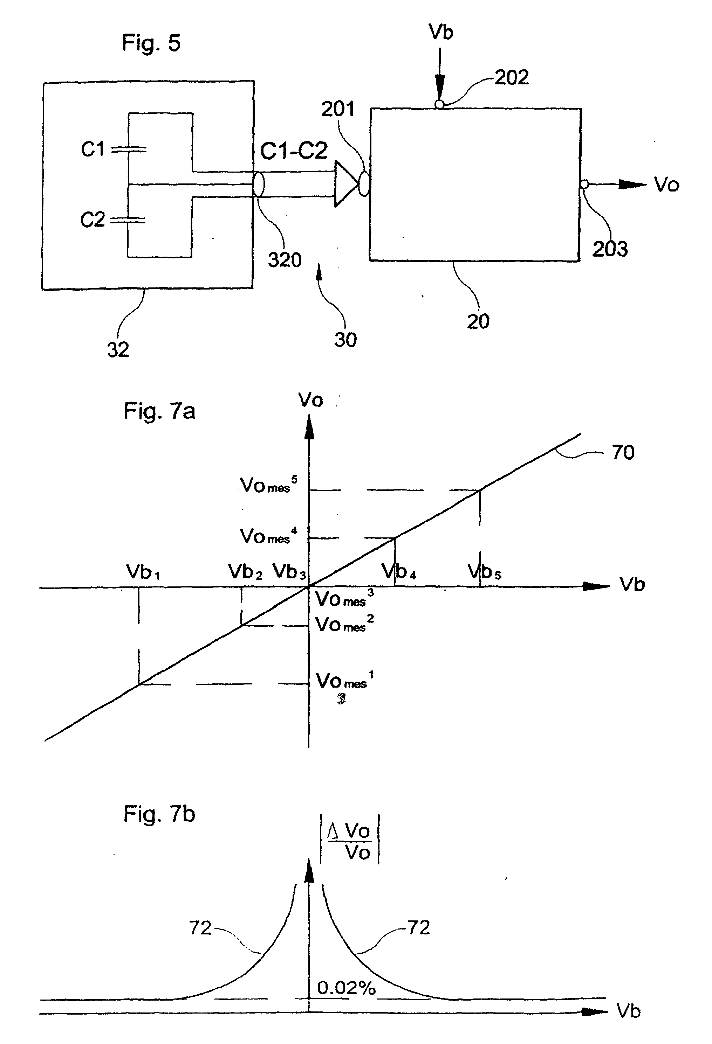

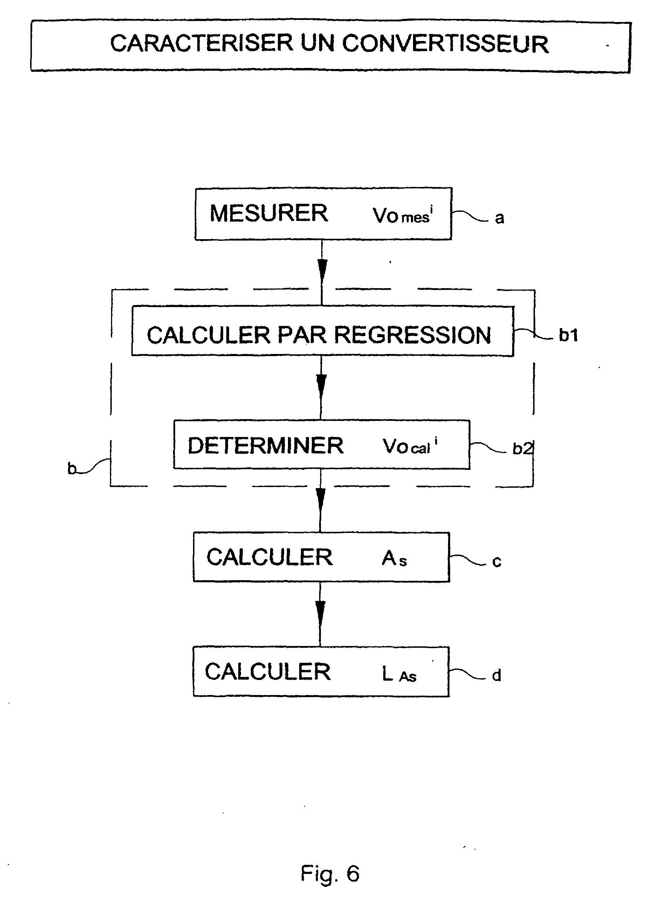

A titre illustratif uniquement, la figure 5 représente un circuit 30 comprenant le convertisseur en tension 20 de la figure 2, qui est connecté à un montage capacitif 32, et destiné à être caractérisé par la procédure de caractérisation selon la présente invention.

On note que la figure 5 représente des objets désignés par des références qui sont utilisées pour désigner des objets décrits en relation avec la figure 2. En effet, les références utilisées pour désigner des objets dans les figures 2 et 5, désignent les mêmes objets dans les deux figures, notamment en relation avec le convertisseur 20.

En outre, comme le représente la figure 5, le montage capacitif 32 comprend une borne de connexion 320 connecté à la borne d'entrée 201 du convertisseur 20. Et le montage capacitif 32 a une structure telle que décrite ci-dessus. Autrement dit, ce montage est constitué d'un circuit dont le schéma électrique équivalent est proche de celui du capteur de la figure 1, c'est-à-dire de deux capacités C1 et C2 connectées en série. Ainsi, le montage capacitif 32 est agencé de manière à fournir, par la borne 320, une différence de capacité C1-C2 au convertisseur 20.

On rappelle que la tension de sortie Vo du convertisseur 20 est une fonction de la différence de capacité C1-C2 et de la tension de polarisation Vb.

On notera que le convertisseur 20 reçoit, par la borne 202, la tension de polarisation Vb qui est fournie par des moyens de fourniture classiques (non représentés) agencés de manière à pouvoir fournir une valeur variable de la tension de polarisation Vb.

On va maintenant décrire la procédure selon la présente invention, mise en oeuvre pour caractériser le convertisseur 20 dans le circuit 30 de la figure 5.

La figure 6 représente un organigramme de cette procédure.

La procédure selon la présente invention comprend une séquence d'étapes désignées "a" à "d".

L'étape "a" consiste à mesurer au moins trois valeurs expérimentales de la tension de sortie Vo à partir d'au moins trois valeurs respectives de la tension de polarisation Vb. On note que la différence de capacité C1-C2 est maintenue constante.

Les références $Vo_{mes}^1$, $Vo_{mes}^2$ et $Vo_{mes}^3$ désignent respectivement les trois valeurs expérimentales de la tension de sortie Vo, et les références $Vb_1$, $Vb_2$ et $Vb_3$ désignent respectivement les trois valeurs de la tension de polarisation Vb. On note que les valeurs $Vb_1$, $Vb_2$ et $Vb_3$ sont comprises dans la plage de fonctionnement du convertisseur 31.

Au terme de l'étape "a", on obtient ainsi trois couples de valeur $(Vb_1, Vo_{mes}^1)$, $(Vb_2, Vo_{mes}^2)$, $(Vb_3, Vo_{mes}^3)$.

L'étape "a" est suivie de l'étape "b" qui comprend deux sous-étapes désignées "b1" et "b2".

La sous-étape "b1" consiste à déterminer par régression une courbe analytique à partir des trois couples de valeur $(Vb_1, Vo_{mes}^1)$, $(Vb_2, Vo_{mes}^2)$, $(Vb_3, Vo_{mes}^3)$. La courbe obtenue est une représentation analytique de la caractéristique en tension du convertisseur 20, basée sur un modèle analytique qui dépend de la nature du montage capacitif, comme cela va être décrit de façon plus détaillée ci-dessous.

On note que la procédure selon la présente invention est particulièrement avantageuse, puisqu'elle permet de déterminer la caractéristique du convertisseur 20 à partir des valeurs $Vb_1$, $Vb_2$ et $Vb_3$ de la tension de polarisation Vb, contrairement à la procédure classique. En effet, lors de la procédure classique, la caractéristique du convertisseur 20 est déterminée à partir des valeurs de différence de capacité $C1_i$-$C2_i$, pour i = 1, 2, 3, 4, 5, la valeur de la tension de polarisation Vb étant maintenue constante. Il en ressort que la précision de mesure dans la procédure de caractérisation selon la présente invention, est typiquement de l'ordre de 1 mV, ce qui permet de mesurer une différence de capacité de 10 pF avec une précision de 2 fF (1 fF = $10^{-15}$ F), pour une tension de polarisation Vb égale à 5 V, par exemple.

La sous-étape "b1" est suivie de la sous-étape "b2" qui consiste à fournir, à partir de la représentation analytique obtenue à la sous-étape "b1" et des valeurs $Vb_1$, $Vb_2$ et $Vb_3$, trois valeurs calculées de la tension de sortie Vo, qui sont désignées respectivement $Vo_{cal}^1$, $Vo_{cal}^2$ et $Vo_{cal}^3$, et qui correspondent respectivement aux trois valeurs expérimentales $Vo_{mes}^1$, $Vo_{mes}^2$ et $Vo_{mes}^3$.

Dans le cadre de la détermination des performances électriques du convertisseur 20, telles que décrites ci-dessus, la sous-étape "b2" est suivie de l'étape "c" destinée à déterminer le gain As du convertisseur 20, puis de l'étape "d" destinée à déterminer le coefficient $L_{As}$ de ce convertisseur.

Ainsi, l'étape "c" consiste à déterminer, à partir des valeurs expérimentales précédemment mesurées $Vo_{mes}^1$, $Vo_{mes}^2$ et $Vo_{mes}^3$, ainsi que des valeurs calculées respectives $Vo_{cal}^1$, $Vo_{cal}^2$ et $Vo_{cal}^3$, le gain As du convertisseur en effectuant le calcul suivant, pour i, j = 1, 2, 3 et i ≠ j :

$$As = \frac{Vo_{cal}^i - Vo_{cal}^j}{Vb_i - Vb_j}$$

On note que ce gain est calculé avec la précision de mesure relative à la tension de polarisation Vb.

L'étape "c" est suivie de l'étape "d" qui consiste à déterminer, à partir des valeurs expérimentales précédemment mesurées ($Vo_{mes}^1$, $Vo_{mes}^2$, $Vo_{mes}^3$), ainsi que les valeurs calculées respectives ($Vo_{cal}^1$, $Vo_{cal}^2$, $Vo_{cal}^3$), le coefficient de non-linéarité $L_{As}$ du convertisseur en effectuant le calcul suivant :

$$L_{As} = Max_{i,j}\left(\frac{Vo_{mes}^i - Vo_{mes}^i}{Vo_{max} - Vo_{min}}\right)$$

où $Vo_{max} - Vo_{min}$ correspond à la longueur de la plage de variations du signal de sortie.

On note que le coefficient $L_{As}$ est calculé avec la précision de mesure relative à la tension de polarisation Vb.

Comme cela a déjà été mentionné ci-dessus, la courbe obtenue à l'issue de l'étape "b1", est une représentation analytique de la caractéristique en tension du convertisseur 20, basée sur un modèle analytique qui dépend de la nature du montage capacitif 32. On va considérer les deux types de montage capacitif suivants.

Considérons le premier type de montage capacitif qui a une structure dont le schéma électrique équivalent comprend une capacité C1 qui est fixe, et une capacité C2 qui est variable. Dans ce cas, la régression utilisée à l'étape "b1" est polynomiale.

Considérons maintenant le second type de montage capacitif qui a une structure dont le schéma électrique équivalent comprend deux capacités C1 et C2 dont la somme est fixe. Dans ce cas, la régression utilisée à l'étape "b1" est linéaire.

A titre illustratif uniquement, la figure 7a représente une courbe 70 illustrant la régression linéaire de la caractéristique en tension d'un convertisseur en tension, dans le cas où ce dernier est connecté à un montage capacitif du second type.

A cet effet, cinq couples de données sont représentés en figure 7a, et désignés par les références ($Vb_i$, $Vo_{mes}^i$) pour i = 1, 2, 3, 4, 5. Ces couples de données ont été extrapolés par la régression linéaire illustrée par la courbe 70, pour déterminer le gain As et le coefficient $L_{As}$.

On note en figure 7b que l'erreur de mesure sur la tension de sortie Vo est due essentiellement à l'erreur sur la valeur effective de la tension de polarisation Vb.

La figure 7b représente une courbe théorique 72 illustrant une précision relative désignée ΔVo/Vo, qui est liée à la tension de sortie Vo décrite en relation avec la figure 7a, en fonction de la tension de polarisation Vb. On note en figure 7b que la précision de mesure des performances électriques du convertisseur, déterminées par une telle procédure de caractérisation, est entachée d'une erreur qui est typiquement de l'ordre de 0,02 %, cette valeur ayant été établie par la Demanderesse de la présente invention.

Il va de soi pour l'homme de l'art que la description détaillée ci-dessus peut subir diverses modifications sans sortir du cadre de la présente invention. A titre d'exemple, la procédure de caractérisation selon la présente invention, peut être mise en oeuvre pour déterminer la caractéristique d'un convertisseur en courant. A titre de variante également, on peut remplacer la tension de polarisation par un courant de polarisation.

## Revendications

1. Procédure de caractérisation d'un convertisseur en tension ou en courant (20) destiné à être connecté à un montage capacitif (32) :

   - le montage capacitif étant agencé de manière à fournir au convertisseur une différence de capacité (C1-C2); et
   - le convertisseur étant agencé de manière à pouvoir recevoir la différence de capacité fourni par le montage, et un signal électrique de polarisation (Vb), et fournir une tension de sortie (Vo) qui est une fonction de la différence de capacité et du signal de polarisation, la procédure de caractérisation étant destinée à déterminer la caractéristique du convertisseur, illustrant la fonction entre la tension de sortie du convertisseur, la différence de capacité et le signal de polarisation, cette procédure étant **caractérisée en ce qu'**elle comprend une séquence d'étapes qui consiste à faire varier le signal de polarisation, en maintenant constante la différence de capacité, et à mesurer en réponse la tension de sortie.

2. Procédure selon la revendication 1, **caractérisée en ce que** la séquence d'étapes comprend des première et seconde étapes ("a", "b") qui consistent à :

   - mesurer au moins trois valeurs expérimentales ($Vo_{mes}^1$, $Vo_{mes}^2$, $Vo_{mes}^3$) de la tension de sortie, à partir d'au moins trois valeurs respectives du signal de polarisation, ces valeurs étant comprises dans la plage de fonctionnement du convertisseur; et
   - déterminer par régression une courbe analytique à partir des points expérimentaux précédemment mesurés, une telle courbe correspondant à la caractéristique du convertisseur, puis fournir trois valeurs calculées de tension de sortie ($Vo_{cal}^1$, $Vo_{cal}^2$, $Vo_{cal}^3$) correspondant respectivement aux valeurs expérimentales mesurées.

3. Procédure selon la revendication 2, **caractérisée en ce qu'**elle comprend en outre une troisième étape ("c") qui consiste à déterminer, à partir des valeurs expérimentales précédemment mesurées ($Vo_{mes}^1$, $Vo_{mes}^2$, $Vo_{mes}^3$), ainsi que des valeurs calculées respectives ($Vo_{cal}^1$, $Vo_{cal}^2$, $Vo_{cal}^3$), le gain (As) du convertisseur en effectuant le calcul suivant, pour i, j = 1, 2, 3 et i ≠ j .

$$As = \frac{Vo_{cal}^i - Vo_{cal}^j}{Vb_i - Vb_j}$$

ce gain étant calculé avec la précision de mesure relative au signal de polarisation.

4. Procédure selon la revendication 2 ou 3, **caractérisée en ce qu'**elle comprend en outre une quatrième étape ("d") qui consiste à déterminer, à partir des valeurs expérimentales précédemment mesurées ($Vo_{mes}^1$. $Vo_{mes}^2$, $Vo_{mes}^3$), ainsi que des valeurs calculées respectives ($Vo_{cal}^1$, $Vo_{cal}^2$, $Vo_{cal}^3$), le coefficient de non-linéarité ($L_{As}$) du covertisseur en effectuant le calcul suivant :

$$L_{As} = Max_{i,j}\left(\frac{Vo_{mes}^i - Vo_{mes}^i}{Vo_{max} - Vo_{min}}\right)$$

où $Vo_{max}$-$Vo_{min}$ correspond à la longueur de la plage de variations du signal de sortie, ce coefficient étant calculé avec la précision de mesure relative au signal de polarisation.

5. Procédure selon l'une des revendications 2 à 4, le montage capacitif (32) étant constitué d'un capteur capacitif, **caractérisée en ce que** ledit capteur a une première capacité fixe (C1) et une seconde capacité variable (C2), et **en ce que** la régression est polynomiale.

6. Procédure selon l'une des revendications 2 à 4, le montage capacitif (32) étant constitué d'un capteur capacitif, **caractérisée en ce que** ledit capteur a des première et seconde capacités (C1, C2) dont la somme est fixe, et **en ce que** la régression est linéaire.

**Patentansprüche**

1. Verfahren zur Charakterisierung eines Spannungs- oder Strom-Wandlers (20), der dazu bestimmt ist, mit einer kapazitiven Schaltung (32) verbunden zu werden :

- wobei die kapazitive Schaltung so angeordnet ist, dass sie an den Wandler eine Kapazitätsdifferenz (C1 - C2) liefert; und
- der Wandler so beschaffen ist, dass er die von der Schaltung gelieferte Kapazitätsdifferenz und ein elektrisches Vorspannungssignal (Vb) empfangen und eine Ausgangsspannung (Vo) liefern kann, die von der Kapazitätsdifferenz und von dem Vorspannungssignal abhängt, wobei das Charakterisierungsverfahren dazu bestimmt ist, die Charakteristik des Wandlers zu bestimmen, die die Funktion zwischen der Ausgangsspannung des Wandlers, der Kapazitätsdifferenz und dem Vorspannungssignal angibt, wobei dieses Verfahren **dadurch gekennzeichnet ist, dass** es eine Folge von Schritten umfasst, die darin besteht, das Vorspannungssignal unter Konstanthaltung der Kapazitätsdifferenz zu verändern und in Reaktion darauf die Ausgangsspannung zu messen.

2. Verfahren nach Anspruch 1, **dadurch gekennzeichnet, dass** die Schrittfolge einen ersten Schritt und einen zweiten Schritt ("a", "b") umfasst, die darin bestehen :

- wenigstens drei experimentelle Werte ($Vo_{mes}^1$, $Vo_{mes}^2$, $Vo_{mes}^3$) der Ausgangsspannung anhand wenigstens dreier entsprechender Werte des Vorspannungssignals zu messen, wobei diese Werte in dem Betriebsbereich des Wandlers liegen; und
- anhand der vorher gemessenen experimentellen Punkte durch Regression eine analytische Kurve zu bestimmen, wobei eine solche Kurve der Charakteristik des Wandlers entspricht, und dann drei berechnete Werte der Ausgangsspannung ($Vo_{cal}^1$, $Vo_{cal}^2$, $Vo_{cal}^3$) zu liefern, die den jeweiligen gemessenen experimentellen Werten entsprechen.

3. Verfahren nach Anspruch 2, **dadurch gekennzeichnet, dass** es ausserdem einen dritten Schritt ("c") umfasst, der darin besteht, anhand der vorher gemessenen experimentellen Werte ($Vo_{mes}^1$, $Vo_{mes}^2$, $Vo_{mes}^3$) sowie der jeweils berechneten Werte ($Vo_{cal}^1$, $Vo_{cal}^2$, $Vo_{cal}^3$) den Verstärkungsfaktor (As) des Wandlers zu bestimmen, indem die folgende Berechnung für i, j = 1, 2, 3 und i ≠ j ausgeführt wird :

$$As = \frac{Vo_{cal}^i - Vo_{cal}^j}{Vb_i - Vb_j}$$

wobei dieser Verstärkungsfaktor mit der relativen Messgenauigkeit des Vorspannungssignals berechnet wird.

**4.** Verfahren nach Anspruch 2 oder 3, **dadurch gekennzeichnet, dass** es ausserdem einen vierten Schritt ("d") umfasst, der darin besteht, anhand der vorher gemessenen experimentellen Werte ($Vo_{mes}^1$, $Vo_{mes}^2$, $Vo_{mes}^3$) sowie der jeweiligen berechneten Werte ($Vo_{cal}^1$, $Vo_{cal}^2$, $Vo_{cal}^3$) den Nichtlinearitätskoeffizienten ($L_{as}$) des Wandlers zu bestimmen, indem die folgende Berechnung ausgeführt wird :

$$L_{As} = Max_{i,j}\left(\frac{Vo_{mes}^i - Vo_{mes}^i}{Vo_{max} - Vo_{min}}\right)$$

wobei $Vo_{max} - Vo_{min}$ der Länge des Änderungsbereichs des Ausgangssignals entspricht, wobei dieser Koeffizient mit der relativen Messgenauigkeit des Vorspannungssignals berechnet wird.

**5.** Verfahren nach einem der Ansprüche 2 bis 4, bei dem die kapazitive Schaltung (32) durch einen kapazitiven Sensor gebildet ist, **dadurch gekennzeichnet, dass** der Sensor eine erste feste Kapazität (C1) und eine zweite variable Kapazität (C2) besitzt, und dass die Regression polynomisch ist.

**6.** Verfahren nach einem der Ansprüche 2 bis 4, bei dem die kapazitive Schaltung (32) aus einem kapazitiven Sensor gebildet ist, **dadurch gekennzeichnet, dass** der Sensor eine erste und eine zweite Kapazität (C1, C2) besitzt, deren Summe konstant ist, und dass die Regression linear ist.

**Claims**

**1.** Characterisation procedure for a voltage or current converter (20) intended to be connected to a capacitive circuit (32):

- the capacitive circuit being arranged so as to provide a capacitance difference (C1-C2) to the converter; and
- the converter being arranged so as to be able to receive the capacitance difference provided by the circuit, and an electric biasing signal (Vb), and to provide an output voltage (Vo) which is a function of the capacitance difference and the biasing signal, the characterisation procedure being intended to determine the characteristic of the converter, illustrating the function between the converter output voltage, the capacitance difference and the biasing signal, this procedure being **characterised in that** it includes a sequence of steps which consist in varying the biasing signal, while keeping the capacitance difference constant, and measuring in response the output voltage.

**2.** Procedure according to claim 1, **characterised in that** the sequence of steps includes first and second steps (« a », « b ») which consist in:

- measuring at least three experimental values ($Vo_{mes}^1$, $Vo_{mes}^2$ and $Vo_{mes}^3$) of the output voltage, from at least three respective values of the biasing signal, said values being comprised within the operating range of the converter; and
- determining by regression an analytical curve from previously measured experimental points, said curve corresponding to the converter characteristic, then providing three calculated output voltage values ($Vo_{cal}^1$, $Vo_{cal}^2$, $Vo_{cal}^3$) corresponding respectively to the measured experimental values.

**3.** Procedure according to claim 2, **characterised in that** it further includes a third step (« c ») which consists in determining, from the previously measured experimental values ($Vo_{mes}^1$, $Vo_{mes}^2$ and $Vo_{mes}^3$), and the respective calculated values ($Vo_{cal}^1$, $Vo_{cal}^2$, $Vo_{cal}^3$), the converter gain (As) by performing the following calculation, for i, j = 1, 2, 3 and i ≠ j:

$$As = \frac{Vo_{cal}^i - Vo_{cal}^j}{Vb_i - Vb_j}$$

said gain being calculated with the accuracy of measurement relating to the bias signal.

**4.** Procedure according to claims 2 or 3, **characterised in that** it further includes a fourth step (« d ») which consists in determining, from previously measured experimental values ($Vo_{mes}^1$, $Vo_{mes}^2$ and $Vo_{mes}^3$), and the respective calculated values ($Vo_{cal}^1$, $Vo_{cal}^2$, $Vo_{cal}^1$), the converter non-linearity coefficient by performing the following calculation:

$$L_{As} = Max_{i,j}\left(\frac{Vo_{mes}^i - Vo_{mes}^j}{Vo_{max} - Vo_{min}}\right)$$

where $Vo_{max}$-$Vo_{min}$ corresponds to the length of the range of variations in the output signal, said coefficient being calculated with the accuracy of measurement relating the bias signal.

5. Procedure according to any of claims 2 to 4, wherein the capacitive circuit (32) being formed of a capacitive sensor, **characterised in that** said sensor has a first fixed capacitance (C1) and a second variable capacitance (C2), and **in that** the regression is polynomial.

6. Procedure according to any of claims 2 to 4, wherein the capacitive circuit (32) being formed of a capacitive sensor, **characterised in that** said sensor has first and second capacitances (C1, C2) the sum of which is fixed, and **in that** the regression is linear.

## Fig. 1

(ART ANTERIEUR)

## Fig. 2

(ART ANTERIEUR)

## Fig. 3　(ART ANTERIEUR)

## Fig. 4a　(ART ANTERIEUR)

## Fig. 4b　(ART ANTERIEUR)

Fig. 5

C1

C2

C1-C2

201

Vb

202

Vo

203

320

30

20

32

Fig. 7a

Vo

70

$Vo_{mes}^5$

$Vo_{mes}^4$

$Vb_1$    $Vb_2$  $Vb_3$    $Vb_4$    $Vb_5$    Vb

$Vo_{mes}^3$

$Vo_{mes}^2$

$Vo_{mes}^1$

Fig. 7b

$\left| \dfrac{\Delta Vo}{Vo} \right|$

72    72

0.02%

Vb

11

CARACTERISER UN CONVERTISSEUR

MESURER  $V_{0\,mes}^{i}$ — a

CALCULER PAR REGRESSION — b1

DETERMINER  $V_{0\,cal}^{i}$ — b2

b

CALCULER  $A_s$ — c

CALCULER  $L_{As}$ — d

Fig. 6